(19) Europäisches Patentamt
European Patent Office
Office européen des brevets

(11) **EP 2 129 195 A1**

(12) **EUROPEAN PATENT APPLICATION**
published in accordance with Art. 153(4) EPC

(43) Date of publication:
**02.12.2009 Bulletin 2009/49**

(51) Int Cl.:
***H05K 1/02*** *(2006.01)*

(21) Application number: **07714020.0**

(22) Date of filing: **09.02.2007**

(86) International application number:
**PCT/JP2007/052408**

(87) International publication number:
**WO 2008/096450 (14.08.2008 Gazette 2008/33)**

(84) Designated Contracting States:
**AT BE BG CH CY CZ DE DK EE ES FI FR GB GR HU IE IS IT LI LT LU LV MC NL PL PT RO SE SI SK TR**

(71) Applicant: **Panasonic Corporation**
**Kadoma-shi**
**Osaka 571-8501 (JP)**

(72) Inventors:
• **MITSUBORI, Shinichi**
  **Osaka 540-6207 (JP)**

• **KUBO, Tetsuya**
  **Osaka 540-6207 (JP)**

(74) Representative: **Grünecker, Kinkeldey,**
**Stockmair & Schwanhäusser**
**Anwaltssozietät**
**Leopoldstrasse 4**
**80802 München (DE)**

(54) **CIRCUIT BOARD, MULTILAYER CIRCUIT BOARD, AND ELECTRONIC DEVICE**

(57) It is an object to provide a circuit board, a laminating circuit board and an electronic apparatus which can enhance a shock resistance.

A first circuit board 20 has a first substrate 21, an electronic component 23 mounted on the first substrate 21, and a reinforcing member 25. The reinforcing member 25 includes a first portion having a first length which is orthogonal to a longitudinal direction of side portions 31 to 34, a second portion having a second length which is orthogonal to the longitudinal direction of the side portion and provided adjacently to the first portion, a first surface which is provided in the first portion and is fixed to the first substrate 21, a second surface which is provided on an opposite side to the first surface of the first portion and can be fixed to a second substrate 15, a third surface which is provided in the second portion and is fixed to the first substrate 21, and a fourth surface which is provided on an opposite side to the third surface of the second portion and can be fixed to the second substrate 15.

*FIG. 1*

**Description**

TECHNICAL FIELD

The present invention relates to a circuit board having an electronic component mounted on a substrate, a laminating circuit board and an electronic apparatus.

BACKGROUND ART

For example, in a laminating circuit board to be used in an electronic apparatus such as a portable telephone, a first circuit board is laminated and mounted on a second circuit board through a solder ball and an electronic component mounted on the first circuit board functions as a spacer between the first circuit board and the second circuit board (see Patent Document 1).

Patent Document 1 : JP-A-2006-49720 Publication

DISCLOSURE OF THE INVENTION

PROBLEMS THAT THE INVENTION IS TO SOLVE

In the case in which the electronic apparatus is dropped or a shock is applied, a deformation such as a bending deformation or a torsional deformation is generated on the second circuit through a housing.
The deformation also influences the first circuit board. As a result, there is a possibility that the electronic component might slip out of a substrate of the first circuit board or might be broken.
The invention has been made to solve the problems and has an object to provide a circuit board, a laminating circuit board and an electronic apparatus which can enhance a shock resistance.

MEANS FOR SOLVING THE PROBLEMS

A circuit board according to the invention has a circuit board comprising a substrate, an electronic component provided on the substrate, and a reinforcing member including a plurality of side portions coupled like a frame and surrounding the electronic component, at least one of the side portions of the reinforcing member including a first portion having a first length which is orthogonal to a longitudinal direction and a second portion having a second length which is orthogonal to the longitudinal direction of the side portion, and the second length being greater than the first length.
It is possible to illustrate, as the side portion, a structure in which an optional position of a central part or an end in a longitudinal direction is set to be wide to provide the second portion, for example.
An edge portion of the second portion may be a square such as a rectangle with respect to the edge portion of the first portion or may be a curve which is linked to the edge portion of the first portion.
In the invention, the second portion which is wider than the first portion, that is, has a larger sectional area is provided in the side portion. Therefore, it is possible to effectively reinforce the substrate against a bending stress and a torsional stress which are transmitted for an external reason, thereby preventing the electronic component from slipping off or being damaged.
Furthermore, a circuit board according to the invention comprises a substrate, an electronic component mounted on an almost center of a plane of the substrate, and a reinforcing member including a plurality of side portions coupled like a frame, the side portions including a first portion having a first length which is orthogonal to a longitudinal direction of the side portions, a second portion having a second length which is orthogonal to the longitudinal direction of the side portions and provided adjacently to the first portion, a first surface which is provided in the first portion and is fixed to the substrate, a second surface which is provided on an opposite side to the first surface in the first portion and can be fixed to another member, a third surface which is provided in the second portion and is fixed to the substrate, and a fourth surface which is provided on an opposite side to the third surface of the second portion and can be fixed to another member.
In the invention, the second portion of the side portion is fixed to the substrate and another member. Therefore, it is possible to effectively reinforce the substrate against a bending stress and a torsional stress which are transmitted for an external reason, thereby preventing the electronic component from slipping off or being damaged.
Moreover, the circuit board according to the invention is **characterized in that** the second portion is provided by a protruded portion which is protruded from a central part in the longitudinal direction of the side portion toward the electronic component.
In the invention, the second portion is provided by the protruded portion which is protruded from the central part in the longitudinal direction of the side portion. Therefore, a decrease in a mounting area of the substrate can be minimized, and furthermore, the substrate can be effectively reinforced against a bending stress and a torsional stress.

Furthermore, the circuit board according to the invention is **characterized in that** the protruded portions are provided on the side portions, and each of the protruded portions is disposed in a line symmetrical position setting a line passing through a plane center of the reinforcing member to be a boundary.

In the invention, a plurality of protruded portions is disposed in the line symmetrical positions. Therefore, it is possible to effectively reinforce the substrate against a bending stress and a torsional stress.

In addition, the circuit board according to the invention is **characterized in that** two opposed side portions of the reinforcing member include the first portion having the first length which is orthogonal to the longitudinal direction and the second portion having the second length which is orthogonal to the longitudinal direction of the side portion, and the second length is greater than the first length.

In the invention, the first portion and the second portion are provided in the two opposed side portions, respectively. Therefore, a strength of the whole reinforcing member is enhanced.

Moreover, the circuit board according to the invention is **characterized in that** the protruded portion is provided in each of the side portions.

In the invention, the protruded portion is provided in each of the side portions.
Therefore, a bending stress and a torsional stress do not concentrate in a specific place so that the substrate can effectively be reinforced against a bending stress and a torsional stress as the whole reinforcing member.

Furthermore, the circuit board according to the invention is **characterized in that** the reinforcing member has the second length which is greater than a distance between the second portion of the side portion and the electronic component.

In addition, the circuit board according to the invention is **characterized in that** a third length to be a difference between the first length which is orthogonal to the longitudinal direction of the side portion in the first portion and the second length which is orthogonal to the longitudinal direction of the side portion in the second portion is equal to or greater than a half of a difference between a fourth length between a first inner edge portion in the first portion and a second inner edge portion in the side portion which is opposed to the first inner edge portion and a fifth length of the electronic component in a direction of the fourth length.

In the invention, a portion between the first inner edge portion in the first portion and the second inner edge portion in the side portion which is opposed to the first inner edge portion is set to be the fourth length.
Moreover, the length of the electronic component in the direction of the fourth length is set to be the fifth length.
The third length to be a protrusion dimension of the second portion is equal to or greater than a half of the difference between the fourth length and the fifth length. As compared with the case in which the difference is smaller than the half, therefore, it is possible to reinforce the substrate against a bending stress and a torsional stress more effectively.

Furthermore, the circuit board according to the invention is **characterized in that** the second portion is provided by a protruded portion which is protruded from a central part in the longitudinal direction of the side portion toward the electronic component, and a sixth length to be a maximum width in the longitudinal direction of the side portion in the protruded portion is equal to or greater than a half of a difference between a seventh length between a third inner edge portion and a fourth inner edge portion in a pair of side portions opposed to each other which is orthogonal to the side portion and an eighth length of the electronic component in the direction of the seventh length.

In the invention, a portion between the third inner edge portion and the fourth edge portion in a pair of side portions which are orthogonal to the side portion and are opposed to each other is set to be the seventh length.
The length of the electronic component in the direction of the seventh length is set to be the eighth length.
The sixth length to be the maximum width of the protruded portion is equal to or greater than the half of the difference between the seventh length and the eighth length. As compared with the case in which the sixth length is smaller than the half, therefore, it is possible to reinforce the substrate against a bending stress and a torsional stress more effectively.

In addition, a laminating circuit board according to the invention comprises a first substrate, a second substrate, an electronic component mounted on an almost center of a plane of the first substrate, and a reinforcing member including a plurality of side portions coupled like a frame, the side portions including a first portion which is orthogonal to a longitudinal direction, a second portion having a width increased inward from the first portion, a first surface which is provided in the first portion and is fixed to the first substrate, a second surface which is provided on an opposite side to the first surface in the first portion and is fixed to the second substrate, a third surface which is provided in the second portion and is fixed to the first substrate, and a fourth surface which is provided on an opposite side to the third surface in the second portion and is fixed to the second substrate.

In the invention, the second portion of the side portion is fixed to the substrate and another member. Therefore, it is possible to effectively reinforce the substrate against a bending stress and a torsional stress which are transmitted for an external reason. Thus, it is possible to obtain a laminating circuit board which can prevent the electronic component from slipping off or being damaged.

Moreover, an electronic apparatus according to the invention comprises the circuit board.

In the invention, the circuit board is provided. Therefore, it is possible to effectively reinforce the substrate against a bending stress and a torsional stress which are transmitted for an external reason. Thus, it is possible to obtain an electronic apparatus which can prevent the electronic component from slipping off or being damaged.

Furthermore, an electronic apparatus according to the invention comprises the laminating circuit board.

In the invention, the laminating circuit board is provided. Therefore, it is possible to effectively reinforce the substrate against a bending stress and a torsional stress which are transmitted for an external reason. Thus, it is possible to obtain an electronic apparatus which can prevent the electronic component from slipping off and being damaged.

ADVANTAGE OF THE INVENTION

According to the circuit board, the laminating circuit board and the electronic apparatus in accordance with the invention, the reinforcing member is provided. Consequently, it is possible to effectively reinforce the substrate against a bending stress and a torsional stress which are transmitted for an external reason and to prevent the electronic component from slipping off or being damaged. Therefore, it is possible to obtain an advantage that a shock resistance can be enhanced.

BRIEF DESCRIPTION OF THE DRAWINGS

Fig. 1 is an exploded perspective view showing a first embodiment of a circuit board, a laminating circuit board and an electronic apparatus according to the invention.

Fig. 2A is a perspective view showing the circuit board according to the first embodiment and Fig. 2B is an exploded perspective view showing the circuit board according to the first embodiment.

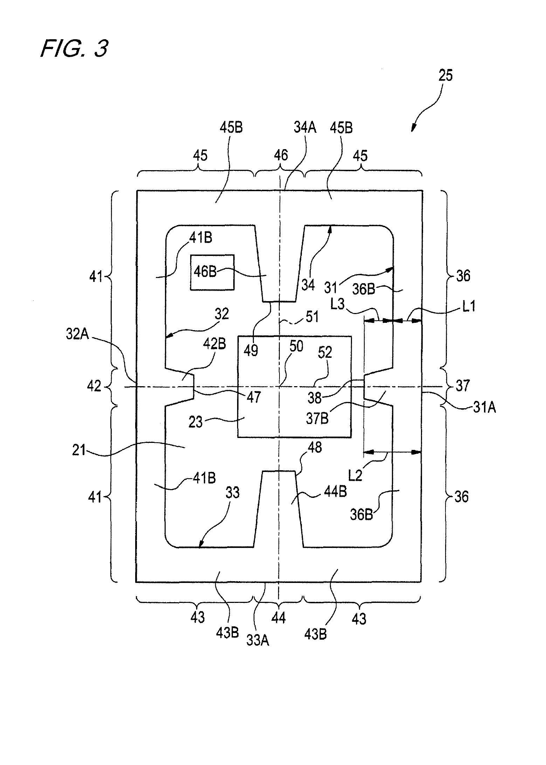

Fig. 3 is a plan view showing the circuit board according to the first embodiment.

Fig. 4 is a plan view for explaining a shape of a reinforcing member according to the first embodiment.

Figs. 5A to 5E are plan views for explaining shapes according to an example 1 and comparative examples 1 to 4 of the reinforcing member.

Figs. 6A to 6G are plan views for explaining shapes according to examples 2 to 8 of the reinforcing member.

Fig. 7 is a plan view showing a second embodiment of the circuit board according to the invention.

Fig. 8 is a plan view showing a third embodiment of the circuit board according to the invention.

Fig. 9 is a plan view showing a fourth embodiment of the circuit board according to the invention.

EXPLANATION OF THE DESIGNATIONS

| | |
|---|---|
| 10 | electronic apparatus |
| 12 | laminating circuit board |
| 15 | second substrate (another member) |
| 20 | first circuit board (circuit board) |
| 21 | first substrate (substrate) |
| 21 A | plane of first substrate (plane of substrate) |
| 23 | electronic component |
| 25, 80, 90, 100 | reinforcing member |
| 31 to 34 | first to fourth side portions (a plurality of side portions) |
| 36, 41, 43, 45 | first portion |
| 36A, 41A, 43A, 45A | first surface |
| 36B, 41B, 43B, 45B | second surface |
| 36C | first inner edge portion |
| 37, 42, 44, 46 | second portion |
| 37A, 42A, 44A, 46A | third surface |
| 37B, 42B, 44B, 46B | fourth surface |
| 38, 47, 48, 49 | first to fourth protruded portions (protruded portions) |
| 41C | second inner edge portion |
| 43C | third inner edge portion |
| 45C | fourth inner edge portion |
| 50 | plane center |

| 51 | first centerline (line) |
|---|---|
| 52 | second centerline (line) |
| L1 | first length |
| L2 | second length |
| L3 | third length |
| L4 | fourth length |
| L5 | fifth length |
| L6 | sixth length |
| L7 | seventh length |
| L8 | eighth length |

BEST MODE FOR CARRYING OUT THE INVENTION

(First Embodiment)

A circuit board, a laminating circuit board and an electronic apparatus according to an embodiment of the invention will be described below with reference to the drawings.

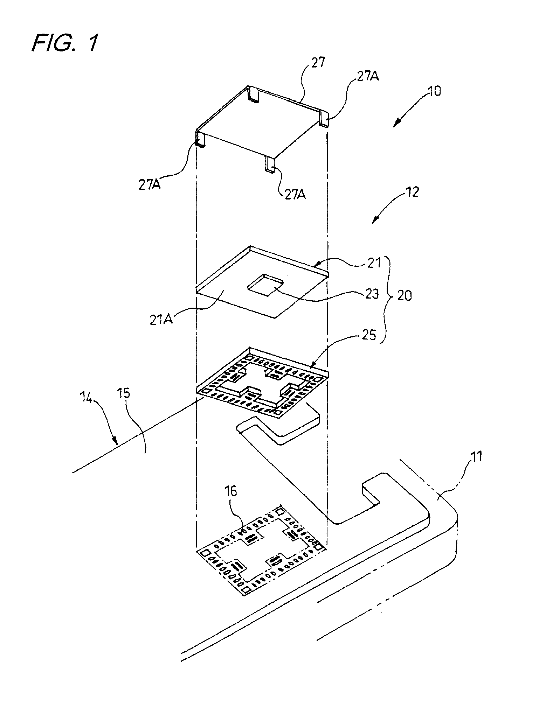

As shown in Fig. 1, an electronic apparatus 10 according to a first embodiment is a folding portable terminal as an example, and a laminating circuit board 12 is provided in a subpanel (a housing) 11.

The laminating circuit board 12 includes a second circuit board 14 having a land 16 formed on a second substrate 15, and a first circuit board (a circuit board) 20 laminated on the second circuit board 14 through a connection to the land 16.

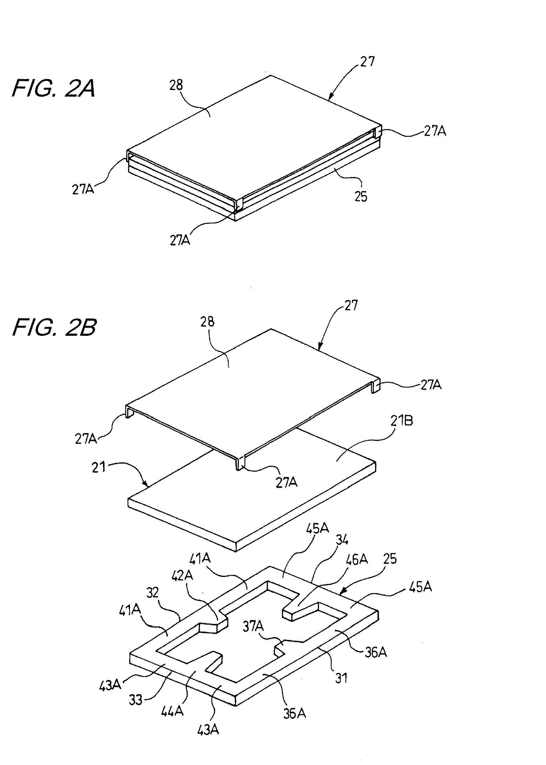

The first circuit board 20 includes a first substrate (a substrate) 21, an electronic component 23 mounted on an almost center of a plane 21A of the first substrate 21, a reinforcing member (a connector) 25 provided on the plane 21A of the first substrate 21, and a sealed cover 27 provided on a plane 21B (see Figs. 2A and 2B) on an opposite side to the plane 21 A of the first substrate 21.

The reinforcing member 25 and the sealed cover 27 are attached to the first substrate 21 so that the first circuit board 20 is then laminated on the second circuit board 14.

In the shield cover 27, a leg portion 27A is bonded to the first substrate 21 and a top surface 28 is held in a separating state at a regular interval with respect to the plane 21B of the first substrate 21.

The reinforcing member 25 is a connector provided between the first substrate 21 and the second substrate 15 and serving to connect the first substrate 21 to the second substrate 15 through a connection to the land 16 of the second substrate 15.

As shown in Fig. 2B, the reinforcing member 25 includes first to fourth side portions (a plurality of side portions) 31 to 34 coupled to take a shape of a rectangular frame (a frame shape).

The first side portion 31 is a plate-shaped portion formed like a band.

The first side portion 31 is constituted by a first portion 36 having a first length L1 which is orthogonal to a longitudinal direction of the first side portion 31, a second portion 37 having a second length L2 which is orthogonal to the longitudinal direction of the first side portion 31 and provided adjacently to the first portion 36, a first surface 36A (see Fig. 2B) which is provided in the first portion 36 and is fixed to the first substrate 21, a second surface 36B which is provided on an opposite side to the first surface 36A of the first portion 36 and can be fixed to the second substrate 15 (another member), a third surface 37A (see Fig. 2B) which is provided in the second portion 37 and is fixed to the first substrate 21, and a fourth surface 37B which is provided on an opposite side to the third surface 37A of the second portion 37 and can be fixed to the second substrate 15.

The first surface 36A and the third surface 37A are fixed to the first substrate 21 through a solder, for example. However, the solder is not restricted but it is also possible to carry out a fixation by adherence, contact bonding or fusion and to mechanically engage a certain area.

The second surface 36B and the fourth surface 37B are fixed to the second substrate 21 through a solder, for example. The solder is not restricted but it is also possible to carry out a fixation by adherence, contact bonding or fusion and to mechanically engage a certain area.

In the same manner as the first side portion 31, the second side portion 32 is constituted by a first portion 41, a second portion 42, a first surface 41A (see Fig. 2B), a second surface 4 1 B, a third surface 42A (see Fig. 2B), and a fourth surface 42B.

In the same manner as the first side portion 31, the third side portion 33 is constituted by a first portion 43, a second portion 44, a first surface 43A (see Fig. 2B), a second surface 43B, a third surface 44A (see Fig. 2B), and a fourth surface 44B.

In the same manner as the first side portion 31, the fourth side portion 34 is constituted by a first portion 45, a second portion 46, a first surface 45A (see Fig. 2B), a second surface 45B, a third surface 46A (see Fig. 2B), and a fourth surface 46B.

The third surface 37A of the second portion 37 is fixed to the first substrate 21, and furthermore, the fourth surface 37B of the second portion 37 is fixed to the second substrate 15.

Moreover, the third surface 42A of the second portion 42 is fixed to the first substrate 21, and furthermore, the fourth surface 42B of the second portion 42 is fixed to the second substrate 15.

Furthermore, the third surface 44A of the second portion 44 is fixed to the first substrate 21, and furthermore, the fourth surface 44B of the second portion 44 is fixed to the second substrate 15.

In addition, the third surface 46A of the second portion 46 is fixed to the first substrate 21, and furthermore, the fourth surface 46B of the second portion 46 is fixed to the second substrate 15.

Consequently, it is possible to effectively reinforce the first substrate 21 against a bending stress and a torsional stress which are transmitted for an external reason, thereby preventing the electronic component 23 from slipping off or being damaged.

The first to fourth side portions 31 to 34 are similar components, respectively. In the embodiment, accordingly, the first side portion 31 in the first to fourth side portions 31 to 34 will be described as a typical example in detail in place of the explanation of the second to fourth side portions 32 to 34.

The first portion 36 of the first side portion 31 is a band-shaped portion formed in a certain width (the first length L1).

The second portion 37 of the first side portion 31 is provided by a first protruded portion 38 protruded from a central part 31A in the longitudinal direction of the first side portion 31 toward the electronic component 23. More specifically, the second portion 37 includes the first protruded portion 38.

The second portion 42 of the second side portion 32 is provided by a second protruded portion 47 which is protruded from a central part 32A in the longitudinal direction of the second side portion 32 toward the electronic component 23. More specifically, the second portion 42 includes the second protruded portion 47.

The second portion 44 of the third side portion 33 is provided by a third protruded portion 48 which is protruded from a central part 33A in the longitudinal direction of the third side portion 33 toward the electronic component 23. More specifically, the second portion 44 includes the third protruded portion 48.

The second portion 46 of the fourth side portion 34 is provided by a fourth protruded portion 49 which is protruded from a central part 34A in the longitudinal direction of the fourth side portion 34 toward the electronic component 23. More specifically, the second portion 46 includes the fourth protruded portion 49.

Thus, the second portions 37, 42, 44 and 46 are provided by the first to fourth protruded portions 38, 47, 48 and 49 which are protruded from the central parts 31A to 34A in the longitudinal direction of the first to fourth side portions 31 to 34.

By minimizing the first to fourth protruded portions 38, 47, 48 and 49, it is possible to minimize a decrease in a mounting area of the first substrate 21, and furthermore, to effectively reinforce the substrate against a bending stress and a torsional stress.

The first protruded portion 38 and the second protruded portion 47 are disposed in line symmetrical positions with a first centerline (line) 51 passing through a plane center 50 of the reinforcing member 25 set to be a boundary.

The third protruded portion 48 and the fourth protruded portion 49 are disposed in line symmetrical positions with a second centerline (line) 52 passing through the plane center 50 of the reinforcing member 25 set to be a boundary.

Furthermore, the first to fourth protruded portions 38, 47, 48 and 49 are formed to be trapezoids in such a manner that they are tapered from base ends toward tip portions, respectively.

Thus, the first to fourth protruded portions 38, 47, 48 and 49 are provided in the first to fourth side portions 31 to 34, respectively. Consequently, a bending stress and a torsional stress do not concentrate in a specific place of the reinforcing member 25 but the first substrate 21 can be effectively reinforced by the whole reinforcing member 25 against the bending stress and the torsional stress which are applied to the first substrate 21.

In addition, the first protruded portion 38 and the second protruded portion 47 are disposed in the line symmetrical positions about the first centerline 51, and the third protruded portion 48 and the fourth protruded portion 48 are disposed in the line symmetrical positions about the second centerline 52. Therefore, it is possible to effectively reinforce the first substrate 21 against the bending stress and the torsional stress.

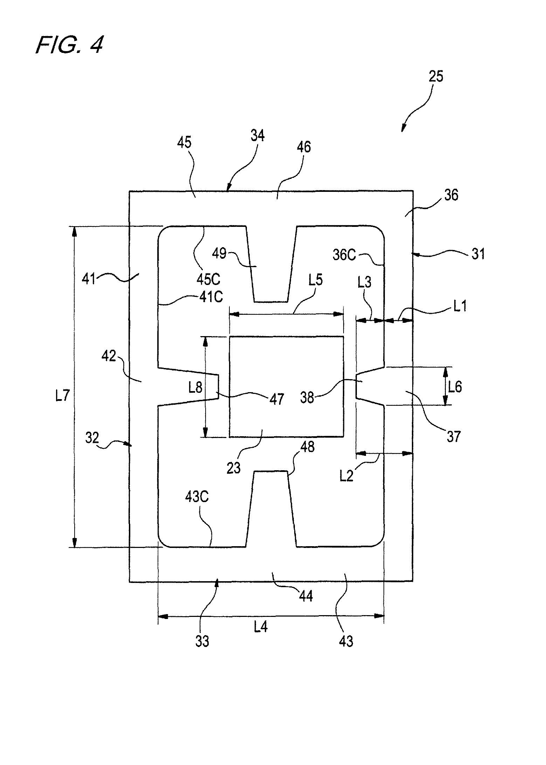

As shown in Fig. 4, a length which is orthogonal to the longitudinal direction of the first side portion 31 in the first portion 36 is represented as the first length L1.

A length which is orthogonal to the longitudinal direction of the first side portion 31 in the second portion 37 is represented as the second length L2.

A difference between the second length L2 and the first length L1, that is, a protrusion dimension of the first protruded portion 38 is represented as a third length L3.

A length between a first inner edge portion 36C in the first portion 36 and a second inner edge portion 41C of the second side portion 32 which is opposed to the first inner edge portion 36C is represented as a fourth length L4.

A length of the electronic component 23 in the direction of the fourth length L4 is represented as a fifth length L5.

The third length L3 is determined to be equal to or greater than a half of a difference between the fourth length L4 and the fifth length L5.

More specifically, the protrusion dimension L3 of the first protruded portion 38 has the following relationship.

$$L3 \geq (L4 - L5) / 2$$

Thus, the third length L3 to be the protrusion dimension of the first protruded portion 38 is equal to or greater than the half of the difference between the fourth length L4 and the fifth length L5. As compared with the case in which the third length L3 is smaller than the half, therefore, it is possible to reinforce the first substrate 21 against a bending stress and a torsional stress more effectively.

As shown in Fig. 4, moreover, a value for a maximum width in the longitudinal direction of the first side portion 31 in the first protruded portion 38 is represented as a sixth length L6.

A length between a third inner edge portion 43C and a fourth inner edge portion 45C in the fourth side portion 34 (a pair of side portions which are opposed to each other) which is orthogonal to the third side portion 33 is represented as a seventh length L7.

A length of the electronic component 23 in the direction of the seventh length L7 is represented as an eighth length L8.

The sixth length L6 is determined to be equal to or greater than a half of a difference between the seventh length L7 and the eighth length L8.

More specifically, the maximum width L6 of the first protruded portion 38 has the following relationship.

$$L6 \quad \geq (L7 - L8) / 2$$

In the reinforcing member 25, the second length L2 is greater than a distance between the second portion 37 of the first side portion 31 and the electronic component 23.

Thus, the sixth length L6 to be the maximum width of the first protruded portion 38 is equal to or greater than the half of the difference between the seventh length L7 and the eighth length L8. As compared with the case in which the sixth length L6 is smaller than the half, therefore, it is possible to reinforce the first substrate 21 against a bending stress and a torsional stress more effectively.

Next, description will be given, based on an example of an experiment, to the fact that it is possible to reduce a stress applied to the electronic component 23 by reinforcing the first substrate 21 with the reinforcing member 25.

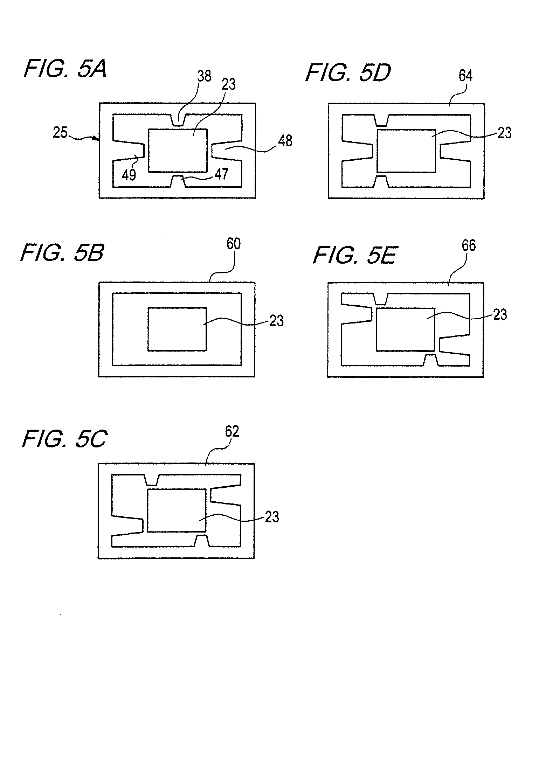

First of all, description will be given, with reference to Figs. 5A to 5E and Table 1, to the fact that it is possible to reduce the stress applied to the electronic component 23 by disposing the first and second protruded portions 38 and 47 of the reinforcing member 25 in line symmetrical positions and disposing the third and fourth protruded portions 48 and 49 in line symmetrical positions.

As a condition for the experiment, the portable terminal to be the electronic apparatus 10 is dropped in a folding state with the subpanel (the subhousing) 11 turned downward.

After the portable terminal to be the electronic apparatus 10 is dropped, the stress applied to the electronic component 23 is obtained and the result is shown in the Table 1.

[Table 1]

| | EXAMPLE 1 | COMPARATIVE EXAMPLE 1 | COMPARATIVE EXAMPLE 2 | COMPARATIVE EXAMPLE 3 | COMPARATIVE EXAMPLE 4 |
|---|---|---|---|---|---|
| DROPPING DIRECTION | DROP IN CLOSING STATE WITH SUBPANEL SURFACE TURNED | | | | |
| DROPPING POSTURE | (FIG. with 10, 11) | | | | |
| REINFORCING CONDITON | DEFAULT | NO PROTRUED PORTION | NONTARGET AND NONCENTER | | |
| SHAPE OF REINFORCING PORTION | TRAPEZOID FIG. 5A | — FIG. 5B | TRAPEZOID FIG. 5C | TRAPEZOID FIG. 5D | TRAPEZOID FIG. 5E |
| STRESS APPLIED TO ELECTRONIC COMPONENT (MPa) | 96 | 118 | 125 | 122 | 120 |

Fig. 5A shows, as an example 1, the reinforcing member 25 according to the first embodiment. In the reinforcing member 25 according to the example 1, the first protruded portion 38 and the second protruded portion 47 are disposed in the line symmetrical positions and the third protruded portion 48 and the fourth protruded portion 49 are disposed in the line symmetrical positions.
Furthermore, the first to fourth protruded portions 38, 47, 48 and 49 are provided on a center.
In addition, the first to fourth protruded portions 38, 47, 48 and 49 are formed to be tapered trapezoids, respectively.
As shown in the Table 1, by providing the reinforcing member 25 according to the example 1, it is possible to efficiently reinforce the first circuit board 20, thereby reducing the stress applied to the electronic component 23 to be 96 MPa.

Fig. 5B shows a reinforcing member 60 as a comparative example 1. The reinforcing member 60 according to the comparative example 1 does not include a protruded portion.

As shown in the Table 1, even if the reinforcing member 60 according to the comparative example 1 is provided, the stress applied to the electronic component 23 is great, that is, 118 MPa.

Fig. 5C shows a reinforcing member 62 as a comparative example 2. Fig. 5D shows a reinforcing member 64 as a comparative example 3. Fig. 5E shows a reinforcing member 66 as a comparative example 4.

In the reinforcing members 62, 64 and 66 according to the comparative examples 2 to 4, the protruded portions are provided in non-line symmetrical positions and are disposed in shifted positions from the center.

As shown in the Table 1, even if the reinforcing member 62 according to the comparative example 2 is provided, the stress applied to the electronic component 23 is great, that is, 125 MPa.

Even if the reinforcing member 64 according to the comparative example 3 is provided, moreover, the stress applied to the electronic component 23 is great, that is, 122 MPa.

Even if the reinforcing member 66 according to the comparative example 4 is provided, furthermore, the stress applied to the electronic component 23 is great, that is, 120 MPa.

From the results, it is apparent that the first circuit board 20 can be efficiently reinforced to reduce the stress applied to the electronic component 23 by disposing the first and second protruded portions 38 and 47 of the reinforcing member 25 in the line symmetrical positions, disposing the third and fourth protruded portions 48 and 49 in the line symmetrical positions, and furthermore, providing the first to fourth protruded portions 38, 47, 48 and 49 on the center.

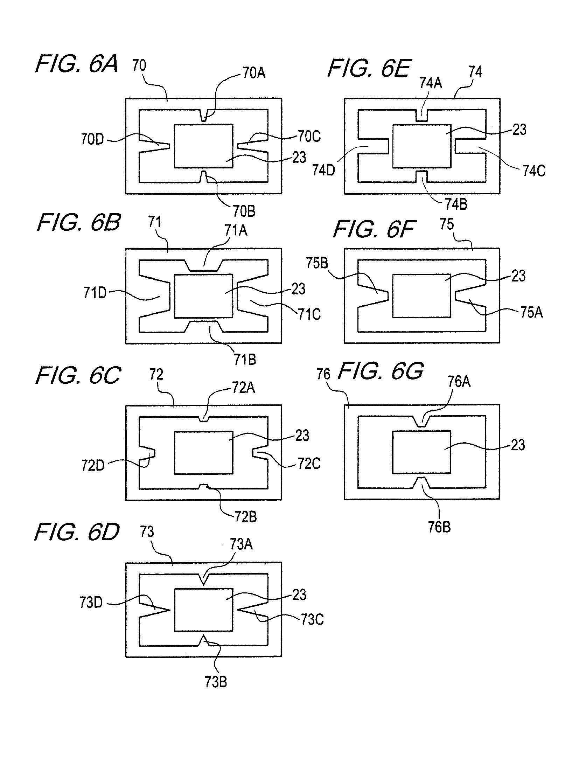

Next, description will be given, with reference to Figs. 6A to 6G and Table 2, to the fact that a shape (a protrusion dimension and a width) of the protruded portion of the reinforcing member influences the stress applied to the electronic component 23.

As a condition for an experiment, the portable terminal to be the electronic apparatus 10 is dropped in a folding state with the subpanel (the subhousing) 11 turned downward.

After the portable terminal to be the electronic apparatus 10 is dropped, the stress applied to the electronic component 23 is obtained and the result is shown in the Table 2.

[Table 2]

| | EXAMPLE 2 | EXAMPLE 3 | EXAMPLE 4 | EXAMPLE 5 | EXAMPLE 6 | EXAMPLE 7 | EXAMPLE 8 |
|---|---|---|---|---|---|---|---|
| DROPPING DIRECTION | DROP IN CLOSING STATE WITH SUBPANEL SURFACE TURNED DOWNWARD | | | | | | |
| DROPPING POSTURE | | | | | | | |
| REINFORCING CONDITION | DEFAULT | | | | | | |
| SHAPE OF REINFORCING PORTION | TRAPEZOID (THIN) FIG. 6A | TRAPEZOID (THICK) FIG. 6B | TRAPEZOID (HALF) FIG. 6C | TRIANGLE FIG. 6D | SQUARE FIG. 6E | TWO IN LONG DIRECTION FIG. 6F | TWO IN SHORT DIRECTION FIG. 6G |
| STRESS APPLIED TO ELECTRONIC COMPONENT (MPa) | 106 | 96 | 107 | 111 | 96 | 114 | 106 |

Fig. 6A shows a reinforcing member 70 as an example 2. In the reinforcing member 70 according to the example 2, first to fourth protruded portions 70A to 70D are trapezoids and are formed to have small widths.

As shown in the Table 2, by providing the reinforcing member 70 according to the example 2, it is possible to reduce the stress applied to the electronic component 23 to be 106 MPa.

However, the widths of the first to fourth protruded portions 70A to 70D are small. As compared with the reinforcing member 25 according to the example 1 shown in the Table 1, therefore, the stress applied to the electronic component 23 is increased.

Fig. 6B shows a reinforcing member 71 as an example 3. In the reinforcing member 71 according to the example 3, first to fourth protruded portions 71A to 71D are trapezoids and are formed to have great widths.

As shown in the Table 2, by providing the reinforcing member 71 according to the example 3, it is possible to reduce the stress applied to the electronic component 23 to be 96 MPa in the same manner as in the example 1.

However, the widths of the first to fourth protruded portions 71 A to 71D are greater than those of the protruded portions 38, 47, 48 and 49 according to the example

1. For this reason, it is preferable to use the reinforcing member 25 according to the example 1 shown in the Table 1.

Fig. 6C shows a reinforcing member 72 as an example 4. In the reinforcing member 72 according to the example 4, first to fourth protruded portions 72A to 72D are trapezoids and are formed to have half protrusion dimensions.

As shown in the Table 2, by providing the reinforcing member 72 according to the example 4, it is possible to reduce the stress applied to the electronic component 23 to be 107 MPa.

However, the protrusion dimensions of the first to fourth protruded portions 72A to 72D are small. As compared with the reinforcing member 25 according to the example 1 shown in the Table 1, therefore, the stress applied to the electronic component 23 is increased.

Fig. 6D shows a reinforcing member 73 as an example 5. In the reinforcing member 73 according to the example 5, first to fourth protruded portions 73A to 73D are formed to be triangles.

As shown in the Table 2, by providing the reinforcing member 73 according to the example 5, it is possible to reduce the stress applied to the electronic component 23 to be 111 MPa.

However, the first to fourth protruded portions 73A to 73D are the triangles. As compared with the reinforcing member 25 according to the example 1 shown in the Table 1, therefore, the stress applied to the electronic component 23 is increased.

Fig. 6E shows a reinforcing member 74 as an example 6. In the reinforcing member 74 according to the example 6, first to fourth protruded portions 74A to 74D are squares and are formed to have greater widths as compared with those in the example 1.

As shown in the Table 2, by providing the reinforcing member 74 according to the example 6, it is possible to reduce the stress applied to the electronic component 23 to be 96 MPa in the same manner as in the example 1.

However, the widths of the first to fourth protruded portions 74A to 74D are greater than those of the protruded portions 38, 47, 48 and 49 according to the example 1. For this reason, it is preferable to use the reinforcing member 25 according to the example 1 shown in the Table 1.

Fig. 6F shows a reinforcing member 75 as an example 7. In the reinforcing member 75 according to the example 7, only two protruded portions 75A and 75B are formed in a longitudinal direction.

As shown in the Table 2, by providing the reinforcing member 75 according to the example 7, it is possible to reduce the stress applied to the electronic component 23 to be 114 MPa.

However, the reinforcing member 75 according to the example 7 has only the two protruded portions 75A and 75B formed in the longitudinal direction. As compared with the reinforcing member 25 according to the example 1 shown in the Table 1, therefore, the stress applied to the electronic component 23 is increased.

Fig. 6G shows a reinforcing member 76 as an example 8. In the reinforcing member 76 according to the example 8, only two protruded portions 76A and 76B are formed in a short direction.

As shown in the Table 2, by providing the reinforcing member 76 according to the example 8, it is possible to reduce the stress applied to the electronic component 23 to be 106 MPa.

However, the reinforcing member 76 according to the example 8 has only the two protruded portions 76A and 76B formed in the short direction. As compared with the reinforcing member 25 according to the example 1 shown in the Table 1, therefore, the stress applied to the electronic component 23 is increased.

As described above, according to the electronic apparatus 10, the laminating circuit board 12 and the first circuit board 20 in accordance with the invention, the reinforcing member 25 is provided. Consequently, it is possible to effectively reinforce the substrate against a bending stress and a torsional stress which are transmitted for an external reason and to prevent the electronic component 23 from slipping off or being damaged. Therefore, it is possible to enhance a shock resistance.

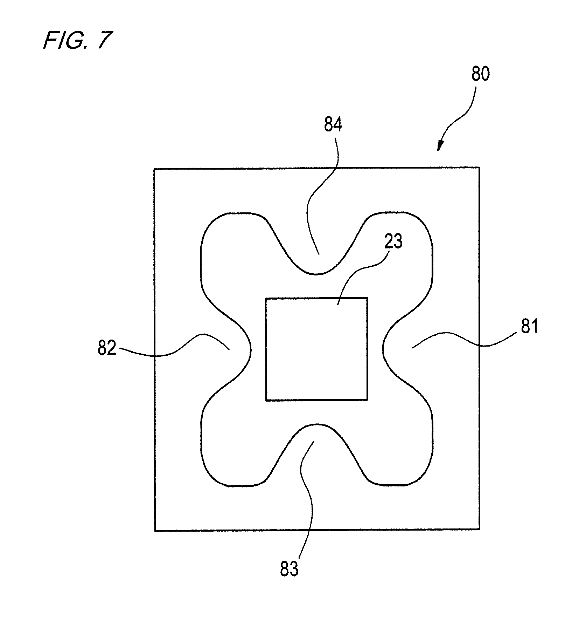

Next, the reinforcing members according to the second to fourth embodiments will be described with reference to Figs. 7 to 9.

In the second to fourth embodiments, the same and similar members as those of the first circuit board 20 according to the first embodiment have the same reference numerals and description will be omitted.

(Second Embodiment)

In a reinforcing member 80 according to a second embodiment shown in Fig. 7, first to fourth protruded portions 81 to 84 are provided in place of the first to fourth protruded portions 38, 47, 48 and 49 according to the first embodiment and the other structures are the same as those in the reinforcing member 25 according to the first embodiment.

The first to fourth protruded portions 81 to 84 are formed to be curved.
Also in the reinforcing member 80 according to the second embodiment, it is possible to obtain the same advantages as those in the first embodiment.

(Third Embodiment)

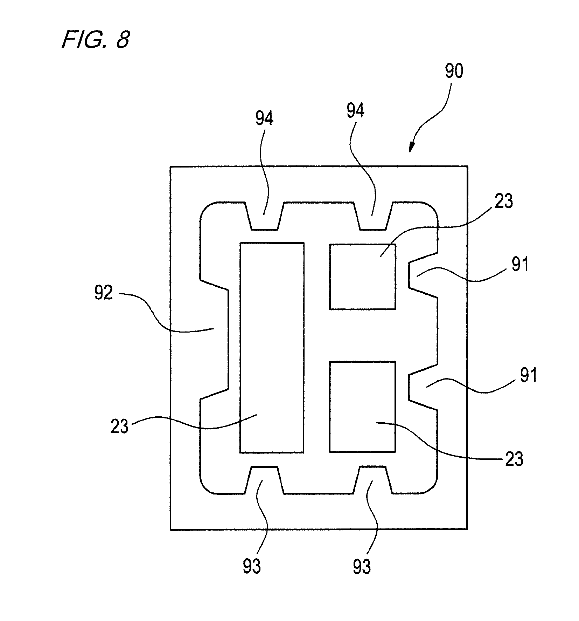

A reinforcing member 90 according to a third embodiment shown in Fig. 8 has a structure in which plural first protruded portions 91 and 91, third protruded portions 93 and 93 and fourth protruded portions 94 and 94 are provided corresponding to the number of electronic components 23 respectively and a width of a second protruded portion 92 is formed to be great corresponding to a shape of the electronic component 23, and the other structures are the same as those in the reinforcing member 25 according to the first embodiment.
According to the reinforcing member 90 in accordance with the third embodiment, it is possible to properly vary the number and width of the protruded portions corresponding to the number and shape of the electronic component 23. Therefore, uses can be enlarged.

(Fourth Embodiment)

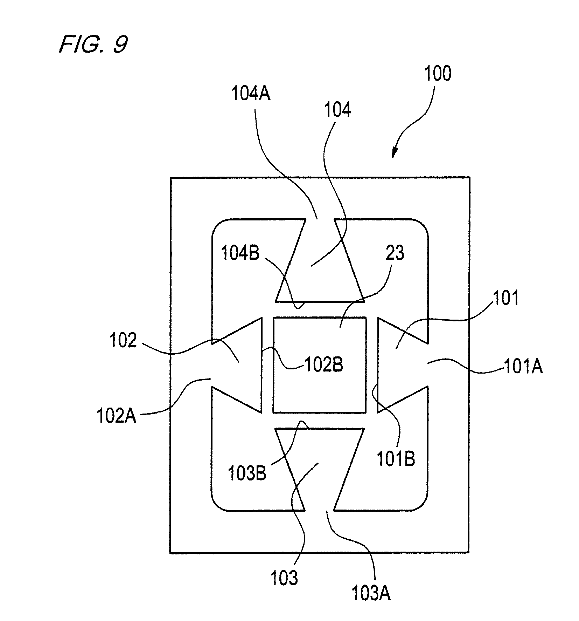

A reinforcing member 100 according to a fourth embodiment shown in Fig. 9 has a structure in which first to fourth protruded portions 101 to 104 are provided in place of the first to fourth protruded portions 38, 47, 48 and 49 according to the first embodiment, and the other structures are the same as those in the reinforcing member 25 according to the first embodiment.
The first to fourth protruded portions 101 to 104 are formed to set the widths of base ends 101A to 104A to be small and to set the widths of tip portions 101B to 104B to be great. As compared with the protruded portions 38, 47, 48 and 49 according to the first embodiment, consequently, they are formed to be inverted trapezoids.
Also in the reinforcing member 100 according to the fourth embodiment, it is possible to obtain the same advantages as those in the first embodiment.

INDUSTRIAL APPLICABILITY

The invention is suitable for an application to a circuit board having an electronic component mounted on a substrate, a laminating circuit board and an electronic apparatus.

**Claims**

1. A circuit board comprising:

   a substrate;
   an electronic component provided on the substrate; and
   a reinforcing member including a plurality of side portions coupled like a frame and surrounding the electronic component,
   at least one of the side portions of the reinforcing member including a first portion having a first length which is orthogonal to a longitudinal direction and a second portion having a second length which is orthogonal to the longitudinal direction of the side portion, and the second length being greater than the first length.

2. A circuit board comprising:

   a substrate;
   an electronic component mounted on an almost center of a plane of the substrate; and
   a reinforcing member including a plurality of side portions coupled like a frame, the side portions including a first portion having a first length which is orthogonal to a longitudinal direction of the side portions, a second portion having a second length which is orthogonal to the longitudinal direction of the side portions and provided adjacently to the first portion, a first surface which is provided in the first portion and is fixed to the substrate, a second surface which is provided on an opposite side to the first surface in the first portion and can be fixed to another member, a third surface which is provided in the second portion and is fixed to the substrate, and a fourth surface which is provided on an opposite side to the third surface of the second portion and can be fixed to another member.

3. The circuit board according to claim 1, wherein the second portion is provided by a protruded portion which is protruded from a central part in the longitudinal direction of the side portion toward the electronic component.

4. The circuit board according to claim 1, wherein the protruded portions are provided on the side portions, and each of the protruded portions is disposed in a line symmetrical position setting a line passing through a plane center of the reinforcing member to be a boundary.

5. The circuit board according to claim 1, wherein two opposed side portions of the reinforcing member include a first portion having a first length which is orthogonal to a longitudinal direction and a second portion having a second length which is orthogonal to the longitudinal direction of the side portion, and the second length is greater than the first length.

6. The circuit board according to claim 2, wherein the protruded portion is provided in each of the side portions.

7. The circuit board according to claim 1, wherein the reinforcing member has the second length which is greater than a distance between the second portion of the side portion and the electronic component.

8. The circuit board according to claim 1, wherein a third length to be a difference between the first length which is orthogonal to the longitudinal direction of the side portion in the first portion and
the second length which is orthogonal to the longitudinal direction of the side portion in the second portion is equal to or greater than a half of a difference between a fourth length between a first inner edge portion in the first portion and a second inner edge portion in the side portion which is opposed to the first inner edge portion and a fifth length of the electronic component in a direction of the fourth length.

9. The circuit board according to claim 1, wherein the second portion is provided by a protruded portion which is protruded from a central part in the longitudinal direction of the side portion toward the electronic component, and a sixth length to be a maximum width in the longitudinal direction of the side portion in the protruded portion is equal to or greater than a half of a difference between a seventh length between a third inner edge portion and a fourth inner edge portion in a pair of side portions opposed to each other which is orthogonal to the side portion and an eighth length of the electronic component in the direction of the seventh length.

10. A laminating circuit board comprising:

   a first substrate;
   a second substrate;
   an electronic component mounted on an almost center of a plane of the first substrate; and
   a reinforcing member including a plurality of side portions coupled like a frame, the side portions including a first portion which is orthogonal to a longitudinal direction, a second portion having a width increased inward from the first portion, a first surface which is provided in the first portion and is fixed to the first substrate, a second surface which is provided on an opposite side to the first surface in the first portion and is fixed to the second substrate, a third surface which is provided in the second portion and is fixed to the first substrate, and a fourth surface which is provided on an opposite side to the third surface of the second portion and is fixed to the second substrate.

11. An electronic apparatus comprising the circuit board according to claim 1.

12. An electronic apparatus comprising the laminating circuit board according to claim 9.

FIG. 1

*FIG. 2A*

*FIG. 2B*

# FIG. 3

## FIG. 4

*FIG. 5A*

*FIG. 5D*

*FIG. 5B*

*FIG. 5E*

*FIG. 5C*

FIG. 6A

FIG. 6E

FIG. 6B

FIG. 6F

FIG. 6C

FIG. 6G

FIG. 6D

FIG. 7

FIG. 8

FIG. 9

<table>
<tr><td colspan="2">**INTERNATIONAL SEARCH REPORT**</td><td>International application No.<br>PCT/JP2007/052408</td></tr>
</table>

A. CLASSIFICATION OF SUBJECT MATTER
*H05K1/02*(2006.01)i

According to International Patent Classification (IPC) or to both national classification and IPC

B. FIELDS SEARCHED

Minimum documentation searched (classification system followed by classification symbols)
H05K1/02, H05K1/18, H05K3/46, H01L23/12

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2007 |
| Kokai Jitsuyo Shinan Koho | 1971-2007 | Toroku Jitsuyo Shinan Koho | 1994-2007 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X | JP 4-75395 A  (Keru Kabushiki Kaisha),<br>10 March, 1992 (10.03.92),<br>Figs. 7, 19<br>& US 5216583 A1 | 1,3 |
| X | JP 2000-243869 A  (NGK Spark Plug Co., Ltd.),<br>08 September, 2000 (08.09.00),<br>Fig. 4<br>(Family: none) | 1 |
| A | JP 2001-291745 A  (NEC Corp.),<br>19 October, 2001 (19.10.01),<br>Full text<br>(Family: none) | 1,3 |

| | |
|---|---|
| ☒ Further documents are listed in the continuation of Box C. | ☐ See patent family annex. |

| | |
|---|---|
| * Special categories of cited documents:<br>"A" document defining the general state of the art which is not considered   to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| | |
|---|---|
| Date of the actual completion of the international search<br>26 April, 2007 (26.04.07) | Date of mailing of the international search report<br>15 May, 2007 (15.05.07) |
| Name and mailing address of the ISA/<br>Japanese Patent Office | Authorized officer |
| Facsimile No. | Telephone No. |

Form PCT/ISA/210 (second sheet) (April 2005)

**INTERNATIONAL SEARCH REPORT**

International application No.

PCT/JP2007/052408

| C (Continuation). DOCUMENTS CONSIDERED TO BE RELEVANT | | |
|---|---|---|
| Category* | Citation of document, with indication, where appropriate, of the relevant passages | Relevant to claim No. |
| A | Microfilm of the specification and drawings annexed to the request of Japanese Utility Model Application No. 111291/1989(Laid-open No. 50371/1991)<br>(Tokin Corp.),<br>16 May, 1991 (16.05.91),<br>Figs. 2, 5<br>(Family: none) | 1, 3 |
| A | JP 11-8332 A (Mitsubishi Electric Corp.),<br>12 January, 1999 (12.01.99),<br>Fig. 3<br>(Family: none) | 1, 3 |
| A | JP 2001-244362 A (NEC Corp.),<br>07 September, 2001 (07.09.01),<br>Full text<br>& TW 479333 B | 1, 3 |
| A | JP 2004-235304 A (NEC Saitama, Ltd.),<br>19 August, 2004 (19.08.04),<br>Full text<br>(Family: none) | 1, 3 |
| A | JP 6-29421 A (Ibiden Co., Ltd.),<br>04 February, 1994 (04.02.94),<br>Fig. 3<br>(Family: none) | 1, 3 |
| A | JP 11-233668 A (Ricoh Co., Ltd.),<br>27 August, 1999 (27.08.99),<br>Fig. 1<br>(Family: none) | 1, 3 |

Form PCT/ISA/210 (continuation of second sheet) (April 2005)

**INTERNATIONAL SEARCH REPORT**

International application No.

PCT/JP2007/052408

**Box No. II      Observations where certain claims were found unsearchable (Continuation of item 2 of first sheet)**

This international search report has not been established in respect of certain claims under Article 17(2)(a) for the following reasons:

1. ☐ Claims Nos.:
   because they relate to subject matter not required to be searched by this Authority, namely:

2. ☐ Claims Nos.:
   because they relate to parts of the international application that do not comply with the prescribed requirements to such an extent that no meaningful international search can be carried out, specifically:

3. ☐ Claims Nos.:
   because they are dependent claims and are not drafted in accordance with the second and third sentences of Rule 6.4(a).

**Box No. III      Observations where unity of invention is lacking (Continuation of item 3 of first sheet)**

This International Searching Authority found multiple inventions in this international application, as follows:
  The inventions in claims 1, 3 is a circuit board comprising a board, an electronic part, and a reinforcement member having projections projecting from the longitudinal center parts of the sides.
The invention in claim 4 is a circuit board in which projections are arranged at the positions symmetric with respect to lines.
The invention in claim 5 is a circuit board in which the opposed two sides of the reinforcement member have first portions and second portions, respectively.
  (continued to extra sheet)

1. ☐ As all required additional search fees were timely paid by the applicant, this international search report covers all searchable claims.

2. ☐ As all searchable claims could be searched without effort justifying an additional fee, this Authority did not invite payment of any additional fee.

3. ☐ As only some of the required additional search fees were timely paid by the applicant, this international search report covers only those claims for which fees were paid, specifically claims Nos.:

4. ☒ No required additional search fees were timely paid by the applicant.   Consequently, this international search report is restricted to the invention first mentioned in the claims; it is covered by claims Nos.: 1, 3

**Remark on Protest**      ☐ The additional search fees were accompanied by the applicant's protest and, where applicable,
the                                   payment of a protest fee.

☐ The additional search fees were accompanied by the applicant's protest but the applicable protest fee was not paid within the time limit specified in the invitation.

☐ No protest accompanied the payment of additional search fees.

Form PCT/ISA/210 (continuation of first sheet (2)) (April 2005)

| INTERNATIONAL SEARCH REPORT | International application No. |
|---|---|
| | PCT/JP2007/052408 |

Continuation of Box No.III of continuation of first sheet(2)

The invention in claim 7 is a circuit board the second length of which is larger than the distance between the second portion and the electronic part.
The invention in claim 8 is a circuit board the third length of which is 1/2 of the difference between the fourth length and the fifth length or longer.
The inventions in claim 9, 12 are a circuit board or an electronic part the sixth length of which is 1/2 of the difference between the seventh length and the eighth length or longer.
The invention in claim 11 is an electronic device having a circuit board.
The inventions in claims 2, 6 are a circuit board having a substrate, an electronic part, and a reinforcement member formed of first portion and second portions  and first to fourth surfaces.
The invention in claim 10 is a multilayer circuit board comprising a first board, a second board, an electronic part, and a reinforcement member having first and second portions and first to fourth surfaces.

Form PCT/ISA/210 (extra sheet) (April 2005)

**EP 2 129 195 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2006049720 A